# EUROPEAN PATENT APPLICATION

(11) **EP 2 903 006 A1**
(43) Date of publication of application: **05.08.2015**
(21) Application number: 13840620.2
(22) Date of filing: 18.09.2013
(51) Int. Cl.: H01B 7/17, H01B 7/22, H01B 11/00

(54) **SHIELDING BRAID STRUCTURE**

(30) Priority: 28.09.2012 JP 2012215541
(71) Applicant: Yazaki Corporation, Tokyo 108-0073 (JP)
(72) Inventor: YANAGIHARA, Yusuke, Kakegawa-shi Shizuoka 437-1421 (JP); IIZUKA, Hayato, Kakegawa-shi Shizuoka 437-1421 (JP)
(74) Representative: Hoffmann Eitle
(86) International application number: PCT/JP2013/075138
(87) International publication number: WO 2014/050659

(57) **Abstract**

A shielding braid structure (7) is formed into a cylindrical shape by combining a plurality of types of element wires (9) and (11) whose magnetic permeabilities are different from each other.

## Description

### TECHNICAL FIELD

The present invention relates to a shielding braid structure, for example, to a shielding braid structure used for shielding of an electric wire and for a coaxial cable installed in a vehicle.

### BACKGROUND ART

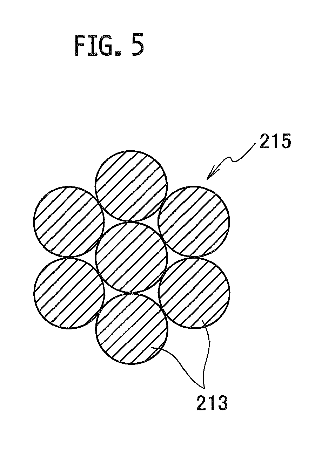

In a conventional coaxial cable, wires (braided element wires 213: see Fig. 5), each of which is formed by twisting together element wires 213 formed of soft copper, for example, are braided into a cylindrical net shape (formed into a braided conductor), and are used as an outer conductor (an outer conductor layer).

In the conventional coaxial cable, the magnetic permeability of the soft copper wire used for the element wire 213 is low and noise easily leaks from gaps in the braid (the net-shaped outer conductor), so that a shielding performance in a low frequency band is low.

To ensure the shielding performance, the outer conductor is thickened, the density of the element wires 213 in the braid is increased, and/or the coaxial cable is covered with a foil. However, the structure is complicated and the weight increases.

Therefore, a coaxial cable 201 as illustrated in Fig. 4 is employed (for example, see Patent Literature 1).

The coaxial cable 201 includes an inner conductor 203, an insulating layer 205, at least one layer of outer conductor layer 207, at least one layer of magnetic outer conductor layer 209, and a sheath 211.

The inner conductor 203 transmits a signal. The insulating layer 205 surrounds the outside of the inner conductor 203. The outer conductor layer 207 is formed of a metal material and surrounds the outside of the inner conductor 203 through the insulating layer 205.

The magnetic outer conductor layer 209 is formed of a magnetic metal material having a magnetic permeability greater than that of the metal material used for the outer conductor layer 207 and surrounds the outside of the outer conductor layer 207. The sheath 211 surrounds the outside of the magnetic outer conductor layer 209.

The outer conductor layer 207 and the magnetic outer conductor layer 209 are also generated by braiding wires, each of which is formed by twisting element wires together, into a cylindrical net shape.

### CITATION LIST

### PATENT LITERATURE

Patent Literature 1: Japanese Patent Laid-Open Publication No. 2004-214137

### SUMMARY OF INVENTION

### TECHNICAL PROBLEM

By the way, in the conventional coaxial cable 201, the magnetic outer conductor layer 209 is provided outside the outer conductor layer 207, so that there is a problem that the diameter (outer diameter) of the coaxial cable 201 is thick.

This problem occurs not only in a coaxial cable but also in a cable that employs a structure in which an electric wire is shielded by using a braided conductor (shielding braid structure) (for example, see Japanese Patent Laid-Open Publication No. 2005-339933).

The present invention is made in view of the above problem, and has an object to provide a shielding braid structure that can ensure the shielding performance without thickening the outer diameter.

### SOLUTION TO PROBLEM

The shielding braid structure of the present invention is characterized to be formed into a cylindrical shape by combining a plurality of types of element wires whose magnetic permeabilities are different from each other.

In the shielding braid structure of the present invention, it is preferable that the plurality of types of element wires is twisted together to form a braided element wire and the plurality of types of element wires is combined by braiding the braided element wires.

In the shielding braid structure of the present invention, it is preferable that the plurality of types of element wires is combined by braiding the plurality of types of element wires.

In the shielding braid structure of the present invention, it is preferable that the plurality of types of element wires includes at least a metal element wire and an element wire formed of a resin material in which fillers having high magnetic permeability are dispersedly contained inside.

In the shielding braid structure of the present invention, it is preferable that the plurality of types of element wires includes at least two types of metal element wires.

In the shielding braid structure of the present invention, it is preferable that the plurality of types of element wires includes at least two types of metal element wires and a resin material in which fillers having high magnetic permeability are dispersedly contained inside.

### BRIEF DESCRIPTION OF DRAWINGS

[Fig. 1] Fig. 1 is a cross-sectional view showing a schematic configuration of a coaxial cable according to an embodiment of the present invention (a cross-sectional view in a plane perpendicular to a longitudinal direction of the coaxial cable).
[Fig. 2] Fig. 2 is a diagram showing an overview of an insulating layer and an outer conductor of the coaxial cable according to the embodiment of the present invention (a diagram showing a state in which a sheath is removed from the coaxial cable), and a horizontal direction in Fig. 2 is the longitudinal direction of the coaxial cable).
[Fig. 3] Fig. 3 is a cross-sectional view of braided element wires of the outer conductor of the coaxial cable according to the embodiment of the present invention (a cross-sectional view in a plane perpendicular to a longitudinal direction of the braided element wires).
[Fig. 4] Fig. 4 is a cross-sectional view of a conventional coaxial cable.
[Fig. 5] Fig. 5 is a cross-sectional view of a braided element wire of an outer conductor of the conventional coaxial cable.

### DESCRIPTION OF EMBODIMENTS

A coaxial cable 1 in which a shielding braid structure 2 (shield braid body) according to the embodiment of the present invention is employed is, for example, laid in a vehicle for use and transmits various signals.

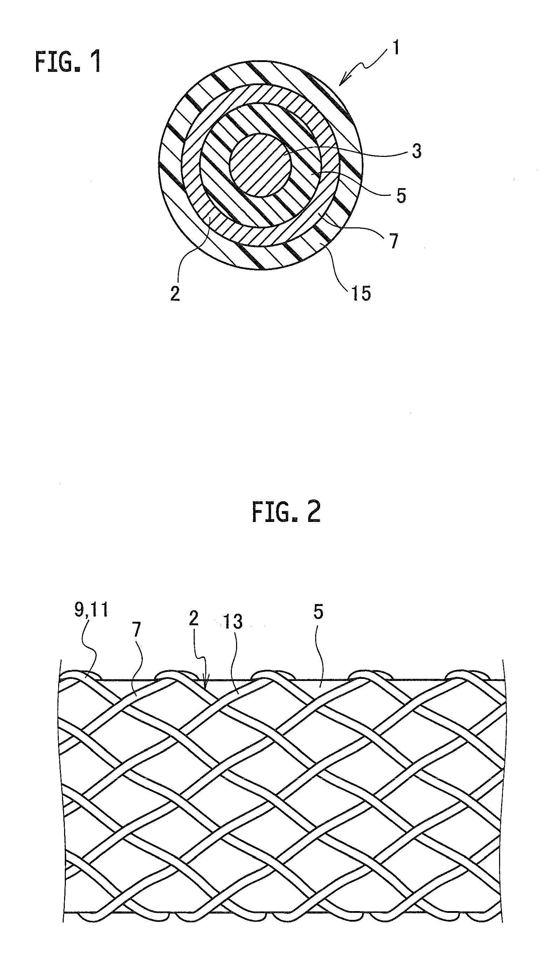

As illustrated in Fig. 1, the coaxial cable 1 includes an inner conductor 3, an insulating layer 5, and an outer conductor 7 (outer conductor layer). The inner conductor 3 transmits a signal and is formed of soft copper in an elongated shape. The inner conductor 3 may be formed of a metal such as copper, copper alloy, aluminum, or aluminum alloy, instead of the soft copper.

More specifically, the inner conductor 3 is formed into, for example, an elongated cylindrical shape. Therefore, the cross section of the inner conductor 3 (the cross section in a plane perpendicular to the longitudinal direction of the coaxial cable 1) has a circular shape.

The insulating layer 5 is formed of an insulating synthetic resin or the like and surrounds the inner conductor 3 outside the inner conductor 3. The insulating layer 5 is provided by extrusion molding, for example, and is formed into an elongated cylindrical shape. The inner diameter of the insulating layer 5 is equal to the outer diameter of the inner conductor 3. The central axis of the insulating layer 5 is the same as that of the inner conductor 3. The insulating layer 5 is in contact with and integrated with the inner conductor 3 to cover the inner conductor 3.

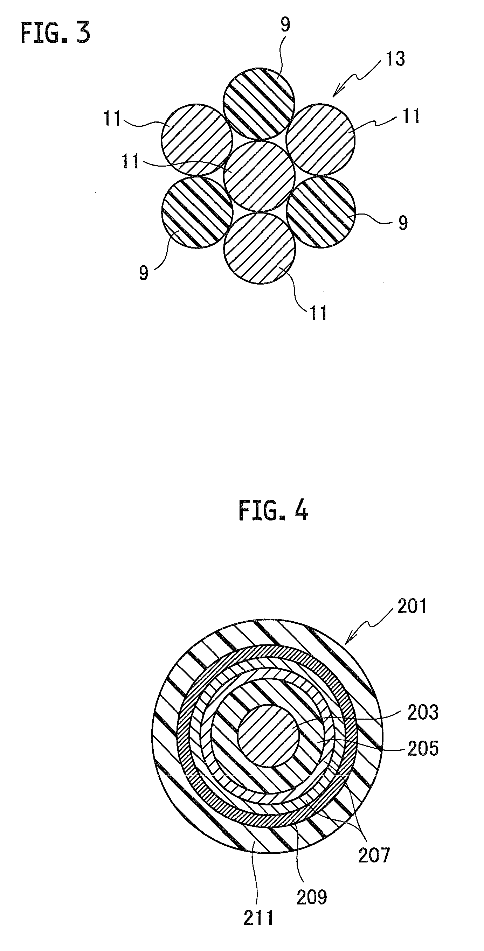

The outer conductor 7 that is formed into a cylindrical shape in the shielding braid structure 2 is formed by combining a plurality of types of element wires 9 and 11 (shield materials) having magnetic permeabilities different from each other. In the present embodiment, the outer conductor 7 is formed from a braided element wire 13 (see Fig. 3), which is formed by twisting together a plurality of types of element wires 9 and 11 having magnetic permeabilities different from each other. The braided element wires 13 (see Fig. 3) are braided, so that the outer conductor 7 is formed as a layer that surrounds the insulating layer 5 outside the insulating layer 5 (see Figs. 1 and 2).

The outer conductor 7 (shielding braid structure 2) is generated by braiding (weaving) the braided element wires 13 (see Fig. 3), each of which is formed by twisting together a plurality of types of element wires (elongated cylindrical element wires) 9 and 11 having magnetic permeabilities different from each other into a string shape, into a net shape having a substantially cylindrical shape while causing the braided element wires 13 to cross each other in order (see Fig. 2). For example, the element wires 9 and 11 have the same outer diameter.

When the outer conductor 7 includes a first element wire 9 and a second element wire 11 (two types of element wires), the magnetic permeability of the first element wire 9 and that of the second element wire 11 are different from each other and the magnetic permeability of the first element wire 9 is greater than that of the second element wire 11. The magnetic permeability of the first element wire 9 is greater than that of the inner conductor 3 and, for example, the magnetic permeability of the second element wire 11 is the same as that of the inner conductor 3.

When the outer conductor 7 includes three or more types of element wires, too, the magnetic permeabilities of the element wires are different from each other. However, when the outer conductor 7 includes three or more types of element wires, the magnetic permeability of at least one type of element wire may be different from that of the other types of element wires. For example, when the outer conductor 7 includes a first element wire, a second element wire, and a third element wire (three types of element wires), the first element wire and the second element wire (an element wire having a material composition different from that of the second element wire) may have the same magnetic permeability and the magnetic permeability of the third element wire may be smaller than that of the first element wire and the second element wire.

The inner diameter of the cylindrical outer conductor 7 is equal to the outer diameter of the insulating layer 5. The central axis of the outer conductor 7 is the same as that of the inner conductor 3. The outer conductor 7 is in contact with and integrated with the insulating layer 5 to cover the insulating layer 5.

A sheath 15 is provided to the coaxial cable 1. The sheath 15 is formed of an insulating material and surrounds the outer conductor 7 outside the outer conductor 7.

The sheath 15 is provided by extrusion molding and is formed into an elongated cylindrical shape. The inner diameter of the sheath 15 is equal to the outer diameter of the outer conductor 7. The central axis of the sheath 15 is the same as that of the inner conductor 3. The sheath 15 is in contact with and integrated with the outer conductor 7 to cover the outer conductor 7.

The outer conductor 7 has a net shape, so that a part of the sheath 15 may be in contact with the insulating layer 5.

As illustrated in Fig. 3, the braided element wire 13 is generated by, for example, twisting seven element wires 9 and 11 together. One second element wire 11 is located at the center, three first element wires 9 and three second element wires 11 are alternately arranged around the second element wire 11 located at the center, and the three first element wires 9 and the three second element wires 11 surround the second element wire 11 located at the center.

More specifically for the coaxial cable 1, the outer conductor 7 is formed by twisting together at least a metal element wire (the second element wire) 11 and an element wire (the first element wire) 9 formed of a resin material (resin material containing high magnetic permeability fillers) in which fillers having high magnetic permeability (for example, powdered ferrite: magnetic material) are dispersedly contained inside.

Although the metal element wire 11 is formed of soft copper, the metal element wire 11 may be formed of a metal such as copper, copper alloy, aluminum, or aluminum alloy, instead of or in addition to the soft copper.

Further, when the metal element wire 11 is formed of soft copper or the like, tin plating (or other plating such as zinc plating) may be applied to the surface of the element wire 11. The resin material of the first element wire 9 may be an insulating material or may be a conductive material.

According to the coaxial cable 1, the outer conductor 7 is formed by combining and twisting a plurality of types of element wires 9 and 11 whose magnetic permeabilities are different from each other, so that a shielding performance in a low frequency band (against electromagnetic waves of 1 Mz or less) is improved without thickening the outer diameter and noise can be absorbed and blocked by the outer conductor 7.

According to the coaxial cable 1, only one layer of the outer conductor 7 is provided, so that the structure is simple and it is possible to prevent the weight from increasing. Further, the coaxial cable 1 can be easily bent.

Further, according to the coaxial cable 1, the outer conductor 7 (the braided element wire 13) includes not only the element wires 9 formed of a resin material in which fillers having high magnetic permeability are dispersedly contained inside, but also the metal element wires 11, so that it is possible to prevent the strength of the outer conductor 7 from decreasing and maintain the strength at a certain value (a specification value). Further, the braided element wire is formed by combining and twisting the element wires 9 and 11, so that it is possible to effectively dissipate heat, which is generated by absorption of noise in the resin material of the element wires 9, through the metal element wires 11.

By the way, in the coaxial cable 1, the outer conductor 7 may be formed by twisting at least two types of metal element wires 9 and 11 together.

In this case, as the two types of metal element wires 9 and 11, it is possible to employ a copper wire (or a soft copper wire, aluminum, and the like) 11 having a low magnetic permeability and a low electrical resistivity and an element wire 9 formed of iron (or an iron alloy such as steel) having a magnetic permeability higher than that of soft copper. Further, tin plating (or other plating such as zinc plating) may be applied to the surfaces of the element wires 9 and 11.

According to the coaxial cable 1, the outer conductor 7 is formed by combining and twisting two types of metal element wires 9 and 11 together, so that it is possible to further increase the strength of the outer conductor 7 and it is also possible to further effectively dissipate the heat generated by the absorption of noise.

In the coaxial cable 1, the outer conductor 7 may be formed by twisting together at least two types of metal element wires and a resin material (resin material containing high magnetic permeability fillers) in which fillers having high magnetic permeability (for example, powdered ferrite: magnetic material) are dispersedly contained inside.

For example, one element wire located at the center of Fig. 3 may be formed of soft copper and six element wires located around the central element wire may be constituted by iron element wires and element wires formed of a resin material in which fillers having high magnetic permeability are dispersedly contained inside. In this case, the six element wires located around the central element wire are formed by alternately arranging three iron element wires and three element wires formed of the resin material.

Also in the case as described above, the outer conductor 7 is formed by combining a plurality of types of element wires 9 and 11 whose magnetic permeabilities are different from each other, so that a shielding performance in a low frequency band (against electromagnetic waves of 1 Mz or less) is improved without thickening the outer diameter and noise can be absorbed and blocked by the outer conductor 7.

Further, only one layer of the outer conductor 7 is provided, so that the structure is simple and it is possible to prevent the weight from increasing. Further, the coaxial cable 1 can be easily bent.

The outer conductor 7 of the coaxial cable 1 may have a plurality of layers instead of one layer. Further, in the outer conductor 7, the braided element wire 13 may be constituted by one type of element wires. Specifically, some of many braided element wires 13 constituting the outer conductor 7 may be constituted by only the first element wires 9 and the other braided element wires may be constituted by only the second element wires 11.

Further, the cylindrical and net-shaped outer conductor 7 may be formed by directly braiding the element wires 9 and 11 without twisting the element wires 9 and 11.

Also in this case, the outer conductor 7 is formed by braiding a plurality of types of element wires 9 and 11 whose magnetic permeabilities are different from each other, so that a shielding performance in a low frequency band (against electromagnetic waves of 1 Mz or less) is improved without thickening the outer diameter and noise can be absorbed and blocked by the outer conductor 7.

Further, only one layer of the outer conductor 7 is provided, so that the structure is simple and it is possible to prevent the weight from increasing. Further, the coaxial cable 1 can be easily bent.

In the above description, a case in which the shielding braid structure 2 is employed in the coaxial cable 1 is described as an example. However, the shielding braid structure 2 may be applied to a structure in which the shielding braid structure 2 is provided to a connector to shield a part of an electric wire extending from the connector (for example, see Japanese Patent Laid-Open Publication No. 2005-339933). In this case, it is desirable that the inner diameter (the outer diameter) of the cylindrical shielding braid structure 2 is expansible.

This application is based upon and claims the benefit of priority of the prior Japanese Patent Application No. 2012-215541, filed on September 28, 2012, the entire content of which is incorporated herein by reference.

### INDUSTRIAL APPLICABILITY

According to the present invention, an effect is obtained in which it is possible to provide a shielding braid structure that can improve shielding performance without thickening the outer diameter.

### REFERENCE SIGNS LIST

- 2: shielding braid structure
- 9: first element wire
- 11: second element wire
- 13: braided element wire

## Claims

1. A shielding braid structure that is formed into a cylindrical shape by combining a plurality of types of element wires whose magnetic permeabilities are different from each other.

2. The shielding braid structure according to claim 1, wherein
the plurality of types of element wires is twisted together to form a braided element wire and the plurality of types of element wires is combined by braiding the braided element wires.

3. The shielding braid structure according to claim 1, wherein
the plurality of types of element wires is combined by braiding the plurality of types of element wires.

4. The shielding braid structure according to any one of claims 1 to 3, wherein
the plurality of types of element wires includes at least a metal element wire and an element wire formed of a resin material in which fillers having high magnetic permeability are dispersedly contained inside.

5. The shielding braid structure according to any one of claims 1 to 3, wherein
the plurality of types of element wires includes at least two types of metal element wires.

6. The shielding braid structure according to any one of claims 1 to 3, wherein
the plurality of types of element wires includes at least two types of metal element wires and a resin material in which fillers having high magnetic permeability are dispersedly contained inside.
